# EUROPÄISCHE PATENTSCHRIFT

(11) **EP 1 507 889 B1**
(45) Veröffentlichungstag und Bekanntmachung des Hinweises auf die Patenterteilung: **06.08.2014**
(21) Anmeldenummer: 03727231.7
(22) Anmeldetag: 09.05.2003
(51) Int. Cl.: C23C 16/455, C30B 25/14, C23C 14/56, C23C 16/04

(54) **VERFAHREN UND VORRICHTUNG ZUR PLASMABEHANDLUNG VON WERKSTÜCKEN**
METHOD AND DEVICE FOR PLASMA TREATING WORKPIECES
PROCEDE ET DISPOSITIF POUR LE TRAITEMENT AU PLASMA DE PIECES

(30) Priorität: 24.05.2002 DE 10223288; 07.06.2002 DE 10225607
(43) Veröffentlichungstag der Anmeldung: 23.02.2005
(73) Patentinhaber: KHS Corpoplast GmbH, 22145 Hamburg (DE)
(72) Erfinder: LITZENBERG, Michael, 21502 Geesthacht (DE); LEWIN, Frank, 22880 Tangstedt (DE); MÜLLER, Hartwig, 22952 Lütjensee (DE); VOGEL, Klaus, 22885 Barsbüttel (DE); ARNOLD, Gregor, 55294 Bodenheim (DE); BEHLE, Stephan, 55239 Gau Odernheim (DE); LÜTTRINGHAUS-HENKEL, Andreas, 64289 Darmstadt (DE); BICKER, Matthias, 55126 Mainz (DE); KLEIN, Jürgen, 55127 Mainz (DE)
(74) Vertreter: Klickow, Hans-Henning
(86) Internationale Anmeldenummer: PCT/DE2003/001504
(87) Internationale Veröffentlichungsnummer: WO 2003/100124

(56) Entgegenhaltungen:
- EP-A- 1 010 773
- WO-A-00/58631
- WO-A-95/22413
- WO-A-99/17334
- DE-C- 924 065

## Beschreibung

Die Erfindung betrifft ein Verfahren zur Plasmabehandlung von Werkstücken, bei dem das Werkstück in eine zumindest teilweise evakuierbare Plasmakammer einer Behandlungsstation eingesetzt wird und bei dem das Werkstück innerhalb der Behandlungsstation von einem Halteelement positioniert wird, sowie bei dem ein Anschluß der Kammer an mindestens eine Betriebsmittelversorgung von einem in der Nähe eines Kammerbodens angeordneten Ventilblock mit mindestens zwei Ventilen gesteuert wird.

Die Erfindung betrifft darüber hinaus eine Vorrichtung zur Plasmabehandlung von Werkstücken, die mindestens eine evakuierbare Plasmakammer zur Aufnahme der Werkstücke aufweist und bei der die Plasmakammer im Bereich einer Behandlungsstation angeordnet ist, sowie bei der die Plasmakammer von einem Kammerboden, einem Kammerdeckel sowie einer seitlichen Kammerwandung begrenzt ist und mindestens ein Halteelement zur Positionierung des Werkstückes aufweist, sowie bei der in einem der Plasmakammer abgewandt angeordneten Bereich des Kammerbodens ein Ventilblock mit mindestens zwei Ventilen zur Steuerung eines Anschlusses der Plasmakammer an mindestens eine Betriebsmittelversorgung angeordnet ist.

Derartige Verfahren und Vorrichtungen werden beispielsweise eingesetzt, um Kunststoffe mit Oberflächenbeschichtungen zu versehen. Insbesondere sind auch bereits derartige Verfahren und Vorrichtungen bekannt, um innere oder äußere Oberflächen von Behältern zu beschichten, die zur Verpackung von Flüssigkeiten vorgesehen sind. Darüber hinaus sind Einrichtungen zur Plasmasterilisation bekannt.

In der PCT-WO 95/22413 wird eine Plasmakammer zur Innenbeschichtung von Flaschen aus PET beschrieben. Die zu beschichtenden Flaschen werden durch einen beweglichen Boden in eine Plasmakammer hineingehoben und im Bereich einer Flaschenmündung mit einem Adapter in Verbindung gebracht. Durch den Adapter hindurch kann eine Evakuierung des Flascheninnenraumes erfolgen. Darüber hinaus wird durch den Adapter hindurch eine hohle Lanze in den Innenraum der Flaschen eingeführt, um Prozeßgas zuzuführen. Eine Zündung des Plasmas erfolgt unter Verwendung einer Mikrowelle.

Aus dieser Veröffentlichung ist es auch bereits bekannt, eine Mehrzahl von Plasmakammern auf einem rotierenden Rad anzuordnen. Hierdurch wird eine hohe Produktionsrate von Flaschen je Zeiteinheit unterstützt.

In der EP-OS 10 10 773 wird eine Zuführeinrichtung erläutert, um einen Flascheninnenraum zu evakuieren und mit Prozeßgas zu versorgen. In der PCT-WO 01/31680 wird eine Plasmakammer beschrieben, in die die Flaschen von einem beweglichen Deckel eingeführt werden, der zuvor mit einem Mündungsbereich der Flaschen verbunden wurde.

Die PCT-WO 00/58631 zeigt ebenfalls bereits die Anordnung von Plasmastationen auf einem rotierenden Rad und beschreibt für eine derartige Anordnung eine gruppenweise Zuordnung von Unterdruckpumpen und Plasmastationen, um eine günstige Evakuierung der Kammern sowie der Innenräume der Flaschen zu unterstützen. Darüber hinaus wird die Beschichtung von mehreren Behältern in einer gemeinsamen Plasmastation bzw. einer gemeinsamen Kavität erwähnt.

Eine weitere Anordnung zur Durchführung einer Innenbeschichtung von Flaschen wird in der PCT-WO 99/17334 beschrieben. Es wird hier insbesondere eine Anordnung eines Mikrowellengenerators oberhalb der Plasmakammer sowie eine Vakuum- und Betriebsmitteizuleitung durch einen Boden der Plasmakammer hindurch beschrieben.

In der DE 92 40 65 C wird ein glockenartiger Vakuumkessel beschrieben, der unter Verwendung von Steuerventilen evakuierbar ist, die im Bereich einer Grundplatte des Vakuumkessels angeordnet sind.

Die EP 10 10 773 A beschreibt eine Verteileinrichtung, bei der im Bereich von Leitungsführungen Steuerventile angeordnet sind.

Bei der überwiegenden Anzahl der bekannten Verfahren werden zur Verbesserung von Barriereeigenschaften des thermoplastischen Kunststoffmaterials durch das Plasma erzeugte Behälterschichten aus Siliziumoxiden mit der allgemeinen chemischen Formel SiOx verwendet. Zusätzlich können in den hierdurch erzeugten Barriereschichten auch Anteile von Kohlenstoff, Wasserstoff und Stickstoff enthalten sein. Derartige Barriereschichten verhindern ein Eindringen von Sauerstoff in die verpackten Flüssigkeiten sowie ein Austreten von Kohlendioxid bei CO₂-haltigen Flüssigkeiten.

Die bislang bekannten Verfahren und Vorrichtungen sind noch nicht in ausreichender Weise dafür geeignet, für eine Massenproduktion eingesetzt zu werden, bei der sowohl ein geringer Beschichtungspreis je Werkstück als auch eine hohe Produktionsgeschwindigkeit erreicht werden muß.

Aufgabe der vorliegenden Erfindung ist es daher, ein Verfahren der einleitend genannten Art derart anzugeben, daß eine Betriebsmittelzuführung zur Behandlungsstation bei kompaktem Aufbau, kurzer Prozeßnebenzeiten und großer Zuverlässigkeit unterstützt wird.

Diese Aufgabe wird erfindungsgemäß dadurch gelöst, daß ein Innenraum eines hohlkörperartigen Werkstückes behandelt wird, daß die mindestens eine Plasmastation von einem rotierenden Plasmarad von einer Eingabepositionierung in eine Ausgabepositionierung überführt wird, daß von einer Plasmastation mehrere Kavitäten bereitgestellt werden und daß von einem Primärvakuumventil des Ventilblockes ein erster Unterdruck und von einem Sekundärvakuumventil des Ventilblockes ein relativ zum ersten Unterdruck niedrigerer zweiter Unterdruck zugeschaltet wird, wobei der Ventilblock als Teil des Kammersockels angeordnet wird.

Weitere Aufgabe der vorliegenden Erfindung ist es, eine Vorrichtung der einleitend genannten Art derart zu konstruieren, daß eine einfache Betriebsmittelzuführung zur Plasmakammer bei kompaktem Aufbau unterstützt wird.
Diese Aufgabe wird erfindungsgemäß dadurch gelöst, daß der Ventilblock ein Primärvakuumventil zur Zuschaltung eines ersten Unterdruckes aufweist, daß der Ventilblock ein Sekundärvakuumventil zur Zuschaltung eines relativ zum ersten Unterdruck niedrigeren Unterdruckes aufweist, daß die Plasmastation zur Beschichtung eines Innenraumes eines hohlkörperartigen Werkstückes ausgebildet ist, daß die mindestens eine Plasmastation von einem rotierenden Plasmarad getragen ist, daß im Bereich der Plasmastation mehrere Kavitäten angeordnet sind, daß der Ventilblock mit dem Kammersockel ein gemeinsames Bauteil ausbildet.

Durch die Anordnung des Ventilblockes mit den Ventilen im Bereich des Kammerbodens wird eine sehr kompakte Baueinheit bereitgestellt, die eine räumlich dichte Anordnung mehrerer Plasmakammern nebeneinander unterstützt und die sowohl die Montage als auch spätere Servicearbeiten erleichtert. Darüber hinaus werden von den jeweiligen Ventilen zur Plasmakammer sehr kurze Verbindungskanäle bereitgestellt, die zu einer Verkürzung der Prozeßnebenzeiten führen, da beispielsweise bei einer Vakuumzuführung auch die Anschlußkanäle evakuiert werden müssen, was zu einem entsprechenden Zeitaufwand führt.

Zur Unterstützung einer Plasmabehandlung von Werkstücken erweist es sich insbesondere als vorteilhaft, daß über mindestens eines der Ventile ein Unterdruck gesteuert wird.

Ein schneller Evakuierungsvorgang bei kompaktem konstruktiven Aufbau wird dadurch unterstützt, daß mindestens zwei Ventile zur Zuschaltung mindestens zwei unterschiedlicher Unterdruckstufen verwendet werden.

Bei einer Beschichtung von hohlen Werkstücken, die mit ihrer Mündung nach unten angeordnet sind, erweist es sich als vorteilhaft, daß eine Evakuierung einer Kavität der Plasmastation durch den Kammerboden hindurch erfolgt.

Eine gerätetechnisch einfache Realisierung wird ebenfalls dadurch unterstützt, daß durch den Kammerboden hindurch Prozeßgas zugeführt wird.

Eine schnelle und gleichmäßige Verteilung des Prozeßgases in einem Innenraum des Werkstückes kann dadurch erreicht werden, daß das Prozeßgas durch eine Lanze hindurch in einen Innenraum des Werkstückes zugeführt wird.

Eine stufenweise Druckabsenkung wird dadurch unterstützt, daß über ein Primärvakuumventil eine erste Unterdruckstufe zugeführt wird.

Verformungen des Werkstückes durch innere und äußere Druckunterschiede werden dadurch vermieden, daß ein Innenraum des Werkstückes und ein weiterer Innenraum der Behandlungsstation mindestens zeitweilig gleichzeitig an die Unterdruckversorgung angeschlossen werden.

Zur schnellen Erreichung eines relativ niedrigen Unterdrukkes erweist es sich als vorteilhaft, daß der Innenraum des Werkstückes und der weitere Innenraum der Plasmakammer mindestens zeitweilig gleichzeitig an eine Unterdruckversorgung mit einem gegenüber der ersten Unterdruckversorgung niedrigeren Druck angeschlossen werden.

Für die Durchführung einer Innenbeschichtung von Werkstükken wird vorgeschlagen, daß der Innenraum des Werkstückes für einen längeren Zeitraum an mindestens eine der Unterdruckversorgungen angeschlossen wird.

Zur Ermöglichung eines problemlosen Öffnens der Plasmakammer ist vorgesehen, daß mindestens ein Teilbereich der Plasmakammer zeitweilig über den Ventilblock an einen Umgebungsdruck angeschlossen wird.

Eine Verformung der Werkstücke durch zu große Druckdifferenzen kann dadurch vermieden werden, daß mindestens ein Teilbereich des Innenraumes des Werkstückes zeitweilig über den Ventilblock an einen Umgebungsdruck angeschlossen wird.

Zur Unterstützung einer steuerbaren Zündung des Plasmas wird vorgeschlagen, daß im Bereich des Kammerdeckels von einem Mikrowellengenerator erzeugte Mikrowellen in die Kavität eingeleitet werden.

Eine typische Anwendung besteht darin, daß ein Werkstück aus einem thermoplastischen Kunststoff behandelt wird.

Insbesondere ist daran gedacht daß ein Innenraum des Werkstückes behandelt wird.

Ein umfangreiches Anwendungsgebiet wird dadurch erschlossen, daß als Werkstück ein Behälter behandelt wird.

Insbesondere ist dabei daran gedacht, daß als Werkstück eine Getränkeflasche behandelt wird.

Eine hohe Produktionsrate bei großer Zuverlässigkeit und hoher Produktqualität kann dadurch erreicht werden, daß die mindestens eine Plasmastation von einem rotierenden Plasmarad von einer Eingabepositionierung in eine Ausgabepositionierung überführt wird.

Eine Vergrößerung der Produktionskapazität bei nur geringfügig gesteigertem gerätetechnischen Aufwand kann dadurch erreicht werden, daß von einer Plasmastation mehrere Kavitäten bereitgestellt werden.

Eine einfache Prozeßgaszuführung wird dadurch unterstützt, daß Plasmagas mindestens einer vorgebbaren Zusammensetzung über mindestens ein Prozeßgasventil mit einer Betriebsmittelversorgung verbunden wird.

Eine typische Anwendung wird dadurch definiert, daß als Plasmabehandlung eine Plasmabeschichtung durchgeführt wird.

Insbesondere ist daran gedacht, daß die Plasmabehandlung unter Verwendung eines Niederdruckplasmas durchgeführt wird.

Bei einer Beschichtung von Werkstücken aus Kunststoff erweist es sich als vorteilhaft, daß eine Plasmapolymerisation durchgeführt wird.

Eine gute Oberflächenhaftung wird dadurch unterstützt, daß durch das Plasma mindestens zum Teil organische Substanzen abgeschieden werden.

Besonders vorteilhafte Verwendungseigenschaften bei Werkstücken zur Verpackung von Lebensmitteln können dadurch erreicht werden, daß durch das Plasma mindestens zum Teil anorganische Substanzen abgeschieden werden.

Bei der Behandlung von Verpackungen ist insbesondere daran gedacht, daß durch das Plasma eine Substanz zur Verbesserung von Barriereeigenschaften des Werkstückes abgeschieden wird.

Zur Unterstützung einer hohen Gebrauchsqualität wird vorgeschlagen, daß zusätzlich ein Haftvermittler zur Verbesserung eines Anhaftens der Substanz auf einer Oberfläche des Werkstückes abgeschieden wird.

Eine hohe Produktivität kann dadurch unterstützt werden, daß in einer gemeinsamen Kavität mindestens zwei Werkstücke gleichzeitig behandelt werden.

Ein weiteres Anwendungsgebiet besteht darin, daß als Plasmabehandlung eine Plasmasterilisation durchgeführt wird.

Ebenfalls ist daran gedacht, daß als Plasmabehandlung eine Oberflächenaktivierung des Werkstückes durchgeführt wird.

Eine sehr kompakte Konstruktion wird dadurch bereitgestellt, daß der Ventilblock in lotrechter Richtung unterhalb des Kammerbodens angeordnet ist.

Eine geringe Bauhöhe wird dadurch unterstützt, daß der Ventilblock im wesentlichen neben dem Kammersockel angeordnet ist.

Zur Gewährleistung einer einfachen konstruktiven Gestaltung sowie einer einfachen Montage ist es möglich, daß der Ventilblock mit dem Kammersockel ein gemeinsames Bauteil ausbildet.

Eine steuerbare Prozeßgaszuführung wird dadurch unterstützt, daß mindestens eines der Prozeßgasventile an ein in lotrechter Richtung nach unten weisendes Kupplungselement angeschlossen ist.

Insbesondere erweist es sich bei einer Verwendung einer positionierbaren Lanze als vorteilhaft, daß das Kupplungselement als Verbindung zu einem die Lanze tragenden Lanzenschlitten ausgebildet ist.

Eine einfache externe Geometrie der Bauteile wird dadurch unterstützt, daß im Bereich des Lanzenschlittens ein Umlenkungskanal für das Plasmagas angeordnet ist, der das Plasmagas vom Kupplungselement in Richtung auf die Lanze leitet.

Eine an unterschiedliche Anwendungsanforderungen in einfacher Weise anpaßbare Ansteuerbarkeit der Ventile wird dadurch bereitgestellt, daß mindestens eines der Ventile als ein elektromagnetisch gesteuertes Ventil ausgebildet ist.

In den Zeichnungen sind Ausführungsbeispiele der Erfindung schematisch dargestellt. Es zeigen:
- Fig. 1: Eine Prinzipskizze einer Mehrzahl von Plasmakammern, die auf einem rotierenden Plasmarad angeordnet sind und bei der das Plasmarad mit Eingabeund Ausgaberädern gekoppelt ist.
- Fig. 2: eine Anordnung ähnlich zu Fig. 1, bei der die Plasmastation jeweils mit zwei Plasmakammern ausgestattet sind,
- Fig. 3: eine perspektivische Darstellung eines Plasmarades mit einer Vielzahl von Plasmakammern,
- Fig. 4: eine perspektivische Darstellung einer Plasmastation mit einer Kavität,
- Fig. 5: eine Vorderansicht der Vorrichtung gemäß Fig. 4 mit geschlossener Plasmakammer,
- Fig. 6: einen Querschnitt gemäß Schnittlinie VI-VI in Fig. 5,
- Fig. 7: eine Darstellung entsprechend Fig. 5 mit geöffneter Plasmakammer,
- Fig. 8: einen Vertikalschnitt gemäß Schnittlinie VIII-VIII in Fig. 7,
- Fig. 9: eine vergrößerte Darstellung der Plasmakammer mit zu beschichtender Flasche gemäß Fig. 6,
- Fig. 10: eine nochmals vergrößerte Darstellung eines Anschlußelementes zur Halterung des Werkstückes in der Plasmakammer,
- Fig. 11: eine schematische Darstellung einer Positionierung eines flaschenförmigen Werkstückes innerhalb der Plasmakammer unter Verwendung eines zangenartigen Halteelementes,
- Fig. 12: eine Darstellung einer geschlossenen Plasmakammer, bei der unterhalb des Kammerbodens ein Ventilblock mit einer Mehrzahl von Ventilen angeordnet ist,
- Fig. 13: die Anordnung gemäß Fig. 12 nach einem Öffnen der Plasmakammer,
- Fig. 14: eine Darstellung eines gegenüber Fig. 12 modifizierten Ventilblockes,
- Fig. 15: einen Vertikalschnitt gemäß Schnittlinie XV-XV in Fig. 14 ohne Darstellung von zangenartigen Halteelementen für die Werkstücke und
- Fig. 16: einen Horizontalschnitt gemäß Schnittlinie XVI-XVI in Fig. 14 ebenfalls ohne dargestelltes zangenartiges Halteelement.

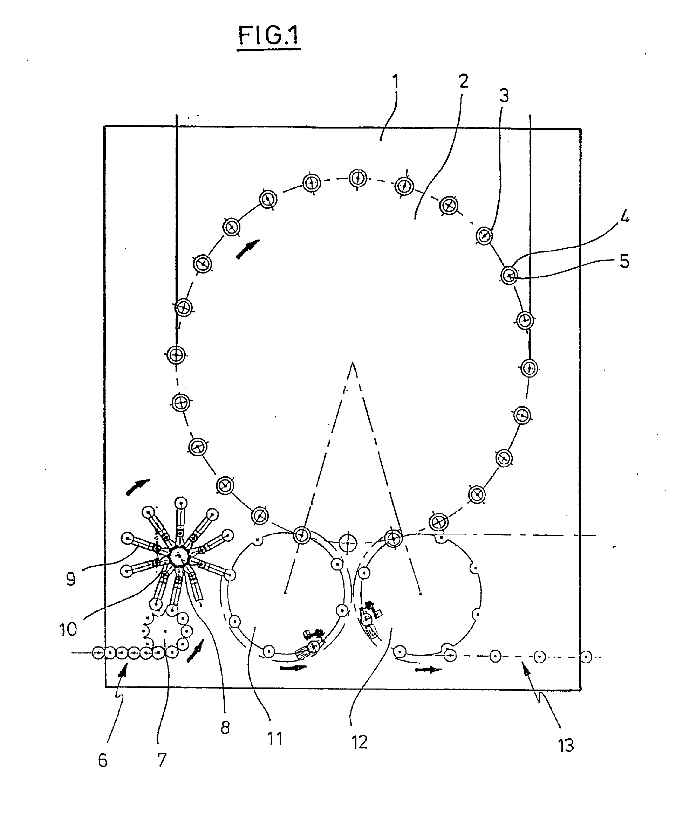

Aus der Darstellung in Fig. 1 ist ein Plasmamodul (1) zu erkennen, das mit einem rotierenden Plasmarad (2) versehen ist. Entlang eines Umfanges des Plasmarades (2) sind eine Mehrzahl von Plasmastationen (3) angeordnet. Die Plasmastationen (3) sind mit Kavitäten (4) bzw. Plasmakammern (17) zur Aufnahme von zu behandelnden Werkstücken (5) versehen.

Die zu behandelnden Werkstücke (5) werden dem Plasmamodul (1) im Bereich einer Eingabe (6) zugeführt und über ein Vereinzelungsrad (7) an ein Übergaberad (8) weitergeleitet, das mit positionierbaren Tragarmen (9) ausgestattet ist. Die Tragarme (9) sind relativ zu einem Sockel (10) des Übergaberades (8) verschwenkbar angeordnet, so daß eine Abstandsveränderung der Werkstücke (5) relativ zueinander durchgeführt werden kann. Hierdurch erfolgt eine Übergabe der Werkstücke (5) vom Übergaberad (8) an ein Eingaberad (11) mit einem relativ zum Vereinzelungsrad (7) vergrößerten Abstand der Werkstücke (5) relativ zueinander. Das Eingaberad (11) übergibt die zu behandelnden Werkstücke (5) an das Plasmarad (2). Nach einer Durchführung der Behandlung werden die behandelten Werkstücke (5) von einem Ausgaberad (12) aus dem Bereich des Plasmarades (2) entfernt und in den Bereich einer Ausgabestrecke (13) überführt.

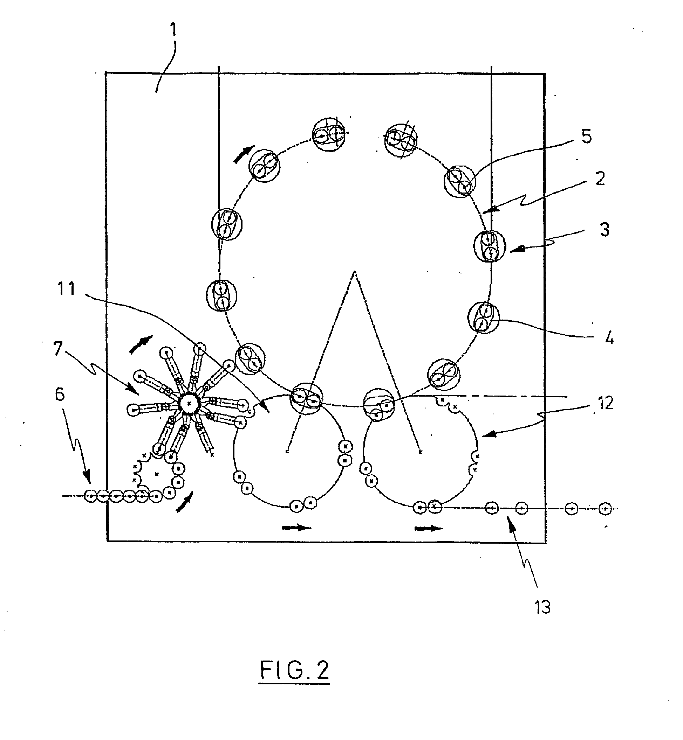

Bei der Ausführungsform gemäß Fig. 2 sind die Plasmastationen (3) jeweils mit zwei Kavitäten (4) bzw. Plasmakammern (17) ausgestattet. Hierdurch können jeweils zwei Werkstücke (5) gleichzeitig behandelt werden. Grundsätzlich ist es hierbei möglich, die Kavitäten (4) vollständig voneinander getrennt auszubilden, grundsätzlich ist es aber auch möglich, in einem gemeinsamen Kavitätenraum lediglich Teilbereiche derart gegeneinander abzugrenzen, daß eine optimale Beschichtung aller Werkstücke (5) gewährleistet ist. Insbesondere ist hierbei daran gedacht, die Teilkavitäten zumindest durch separate Mikrowelleneinkopplungen gegeneinander abzugrenzen.

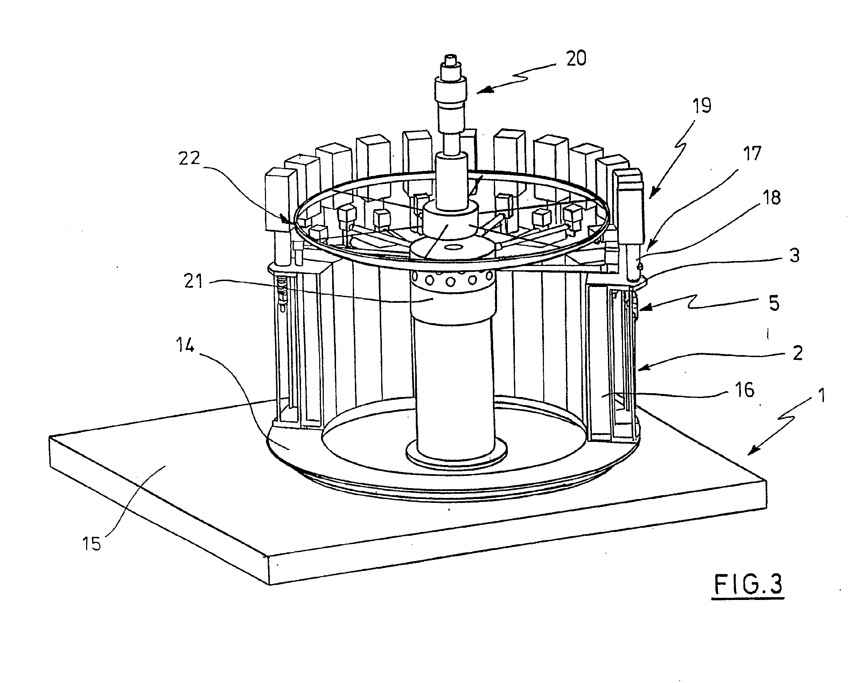

Fig. 3 zeigt eine perspektivische Darstellung eines Plasmamoduls (1) mit teilweise aufgebautem Plasmarad (2). Die Plasmastationen (3) sind auf einem Tragring (14) angeordnet, der als Teil einer Drehverbindung ausgebildet und im Bereich eines Maschinensockels (15) gelagert ist. Die Plasmastationen (3) weisen jeweils einen Stationsrahmen (16) auf, der Plasmakammern (17) haltert. Die Plasmakammern (17) weisen zylinderförmige Kammerwandungen (18) sowie Mikrowellengeneratoren (19) auf.

In einem Zentrum des Plasmarades (2) ist ein Drehverteiler (20) angeordnet, über den die Plasmastationen (3) mit Betriebsmitteln sowie Energie versorgt werden. Zur Betriebsmittelverteilung können insbesondere Ringleitungen (21) eingesetzt werden.

Die zu behandelnden Werkstücke (5) sind unterhalb der zylinderförmigen Kammerwandungen (18) dargestellt. Unterteile der Plasmakammern (17) sind zur Vereinfachung jeweils nicht eingezeichnet.

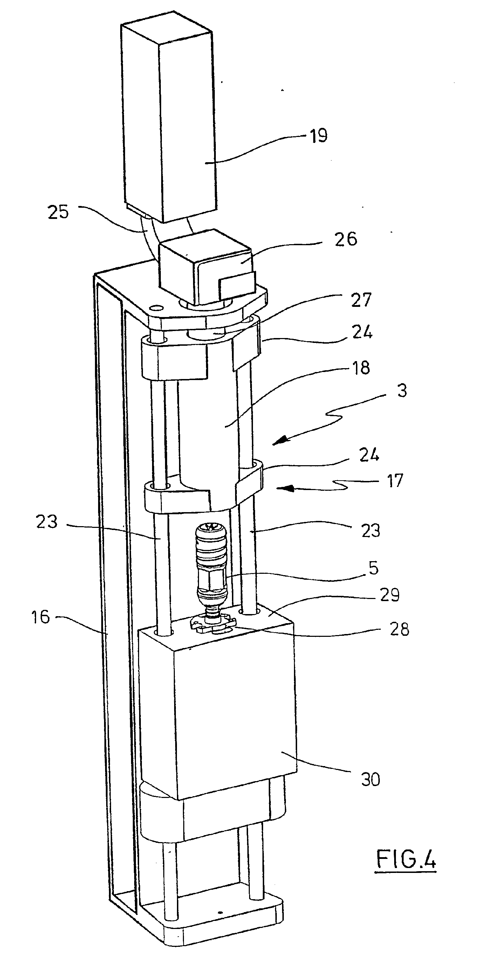

Fig. 4 zeigt eine Plasmastation (3) in perspektivischer Darstellung. Es ist zu erkennen, daß der Stationsrahmen (16) mit Führungsstangen (23) versehen ist, auf denen ein Schlitten (24) zur Halterung der zylinderförmigen Kammerwandung (18) geführt ist. Fig. 4 zeigt den Schlitten (24) mit Kammerwandung (18) in einem angehobenen Zustand, so daß das Werkstück (5) freigegeben ist.

Im oberen Bereich der Plasmastation (3) ist der Mikrowellengenerator (19) angeordnet. Der Mikrowellengenerator (19) ist über eine Umlenkung (25) und einen Adapter (26) an einen Kopplungskanal (27) angeschlossen, der in die Plasmakammer (17) einmündet. Grundsätzlich kann der Mikrowellengenerator (19) sowohl unmittelbar im Bereich des Kammerdekkels (31) als auch über ein Distanzelement an den Kammerdeckel (31) angekoppelt mit einer vorgebbaren Entfernung zum Kammerdeckel (31) und somit in einem größeren Umgebungsbereich des Kammerdeckels (31) angeordnet werden. Der Adapter (26) hat die Funktion eines Übergangselementes und der Kopplungskanal (27) ist als ein Koaxialleiter ausgebildet. Im Bereich einer Einmündung des Kopplungskanals (27) in den Kammerdeckel (31) ist ein Quarzglasfenster angeordnet. Die Umlenkung (25) ist als ein Hohlleiter ausgebildet.

Das Werkstück (5) wird im Bereich eines Dichtelementes (28) positioniert, das im Bereich eines Kammerbodens (29) angeordnet ist. Der Kammerboden (29) ist als Teil eines Kammersockels (30) ausgebildet. Zur Erleichterung einer Justage ist es möglich, den Kammersockel (30) im Bereich der Führungsstangen (23) zu fixieren. Eine andere Variante besteht darin, den Kammersockel (30) direkt am Stationsrahmen (16) zu befestigen. Bei einer derartigen Anordnung ist es beispielsweise auch möglich, die Führungsstangen (23) in vertikaler Richtung zweiteilig auszuführen.

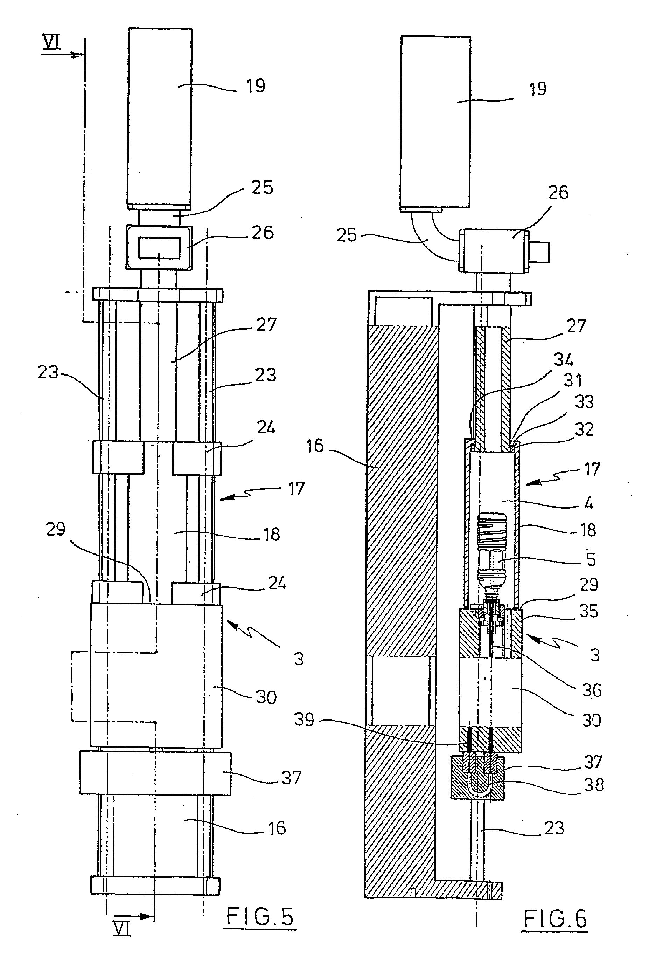

Fig. 5 zeigt eine Vorderansicht der Plasmastation (3) gemäß Fig. 3 in einem geschlossenen Zustand der Plasmakammer (17). Der Schlitten (24) mit der zylinderförmigen Kammerwandung (18) ist hierbei gegenüber der Positionierung in Fig. 4 abgesenkt, so daß die Kammerwandung (18) gegen den Kammerboden (29) gefahren ist. In diesem Positionierzustand kann die Plasmabeschichtung durchgeführt werden.

Fig. 6 zeigt in einer Vertikalschnittdarstellung die Anordnung gemäß Fig. 5. Es ist insbesondere zu erkennen, daß der Kopplungskanal (27) in einen Kammerdeckel (31) einmündet, der einen seitlich überstehenden Flansch (32) aufweist. Im Bereich des Flansches (32) ist eine Dichtung (33) angeordnet, die von einem Innenflansch (34) der Kammerwandung (18) beaufschlagt wird. In einem abgesenkten Zustand der Kammerwandung (18) erfolgt hierdurch eine Abdichtung der Kammerwandung (18) relativ zum Kammerdeckel (31). Eine weitere Dichtung (35) ist in einem unteren Bereich der Kammerwandung (18) angeordnet, um auch hier eine Abdichtung relativ zum Kammerboden (29) zu gewährleisten.

In der in Fig. 6 dargestellten Positionierung umschließt die Kammerwandung (18) die Kavität (4), so daß sowohl ein Innenraum der Kavität (4) als auch ein Innenraum des Werkstückes (5) evakuiert werden können. Zur Unterstützung einer Zuleitung von Prozeßgas ist im Bereich des Kammersokkels (30) eine hohle Lanze (36) angeordnet, die in den Innenraum des Werkstückes (5) hineinverfahrbar ist. Zur Durchführung einer Positionierung der Lanze (36) wird diese von einem Lanzenschlitten (37) gehaltert, der entlang der Führungsstangen (23) positionierbar ist. Innerhalb des Lanzenschlittens (37) verläuft ein Prozeßgaskanal (38), der in der in Fig. 6 dargestellten angehobenen Positionierung mit einem Gasanschluß (39) des Kammersockels (30) gekoppelt ist. Durch diese Anordnung werden schlauchartige Verbindungselemente am Lanzenschlitten (37) vermieden.

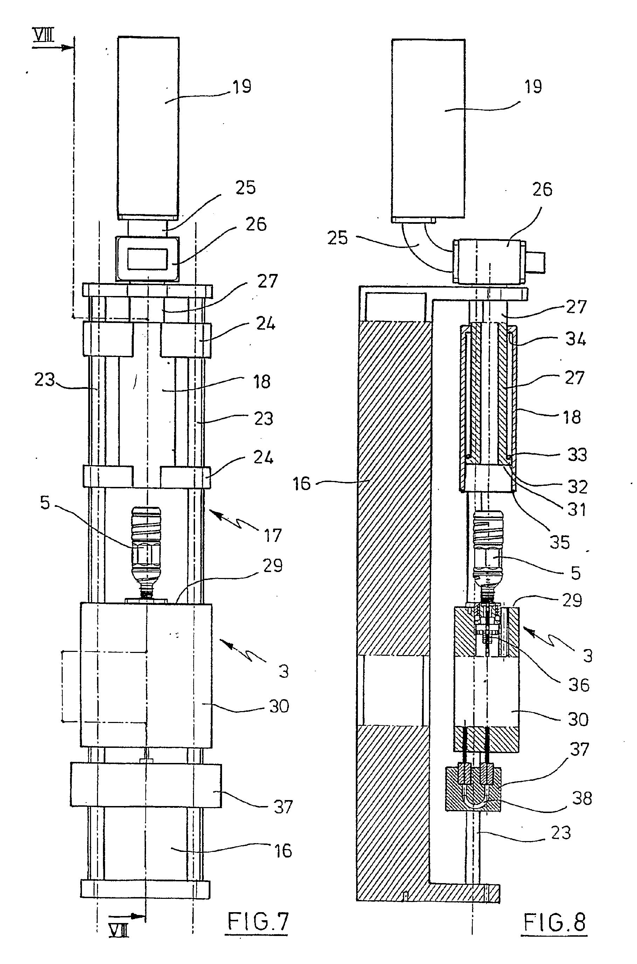

Fig. 7 und Fig. 8 zeigen die Anordnung gemäß Fig. 5 und Fig. 6 in einem angehobenen Zustand der Kammerwandung (18). In diesem Positionierungszustand der Kammerwandung (18) ist es problemlos möglich, das behandelte Werkstück (5) aus dem Bereich der Plasmastation (3) zu entfernen und ein neues zu behandelndes Werkstück (5) einzusetzen. Alternativ zu der in den Zeichnungen dargestellten Positionierung der Kammerwandung (18) in einem durch Verschiebung nach oben erreichten geöffneten Zustand der Plasmakammer (17) ist es auch möglich, den Öffnungsvorgang durch eine Verschiebung einer konstruktiv modifizierten hülsenförmigen Kammerwandung in vertikaler Richtung nach unten durchzuführen.

Im dargestellten Ausführungsbeispiel besitzt der Kopplungskanal (27) eine zylinderförmige Gestaltung und ist im wesentlichen koaxial zur Kammerwandung (18) angeordnet.

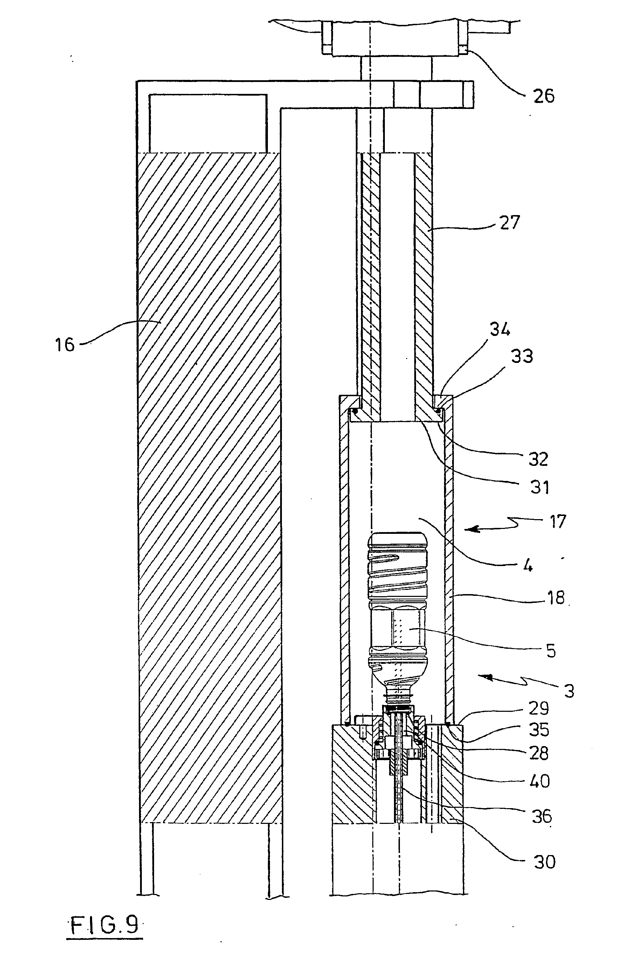

Fig. 9 zeigt den Vertikalschnitt gemäß Fig. 6 in einer vergrößerten teilweisen Darstellung in einer Umgebung der Kammerwandung (18). Zu erkennen ist insbesondere das Übergreifen des Innenflansches (34) der Kammerwandung (18) über den Flansch (32) des Kammerdeckels (31) und die Halterung des Werkstückes (5) durch das Halteelement (28). Darüber hinaus ist zu erkennen, daß die Lanze (36) durch eine Ausnehmung (40) des Halteelementes (28) hindurchgeführt ist.

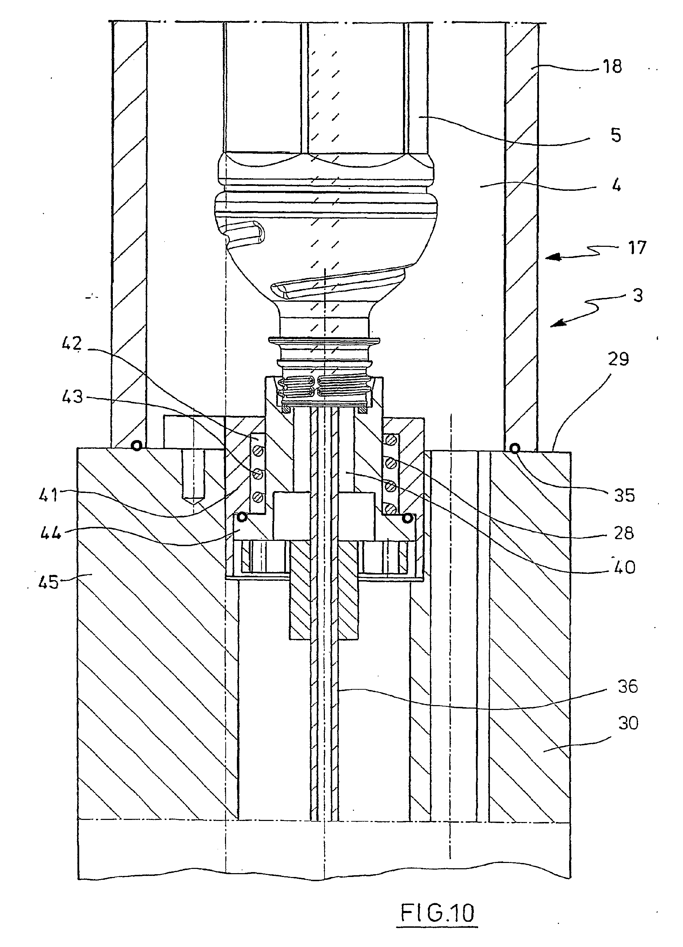

Die Positionierung des Werkstückes (5) im Bereich des Dichtelementes (28) ist in der nochmals vergrößerten Darstellung in Fig. 10 zu erkennen. Das Dichtelement (28) ist in eine Führungshülse (41) eingesetzt, die mit einer Federkammer (42) versehen ist. In die Federkammer (42) ist eine Druckfeder (43) eingesetzt, die einen Außenflansch (44) des Dichtelementes (28) relativ zur Führungshülse (41) verspannt.

In der in Fig. 10 dargestellten Positionierung ist ein an der Lanze (36) montierter Schubteller (45) gegen den Außenflansch (44) geführt und drückt das Dichtelement (28) in seine obere Endpositionierung. In dieser Positionierung ist ein Innenraum des Werkstückes (5) gegenüber dem Innenraum der Kavität (4) isoliert. In einem abgesenkten Zustand der Lanze (36) verschiebt die Druckfeder (43) das Dichtelement (28) relativ zur Führungshülse (41) derart, daß eine Verbindung zwischen dem Innenraum des Werkstückes (5) und dem Innenraum der Kavität (4) geschaffen ist.

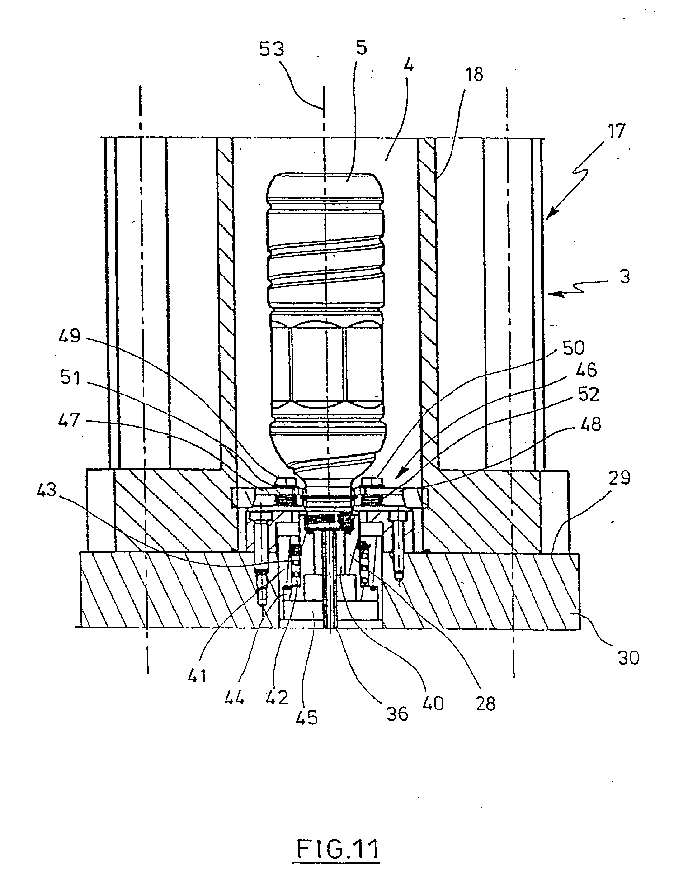

Fig. 11 zeigt die Positionierung des Werkstückes (5) innerhalb der Plasmakammer (17) mit Hilfe eines Halteelementes (46). Das Halteelement (46) ist zangenartig ausgebildet und besitzt zwei verschwenkbar gelagerte Haltearme (47, 48). Die Haltearme (47, 48) sind relativ zu Drehachsen (49, 50) verschwenkbar. Zur Gewährleistung einer automatischen Fixierung des werkstückes (5) durch das Halteelement (46) werden die Haltearme (47, 48) von Federn (51, 52) in eine jeweilige Haltepositionierung gedrückt.

Das Halteelement (46) ist oberhalb des Kammersockels (30) angeordnet, so daß nach einem Anheben der Kammerwandung (18) eine seitliche Zugänglichkeit des Halteelements (46) gegeben ist. Das Werkstück (5) kann hierdurch von einem Positionierelement an das Halteelement (46) übergeben werden, ohne daß eine Hubbewegung des Werkstückes (5) in Richtung einer Kavitätenlängsachse (53) erfolgen muß.

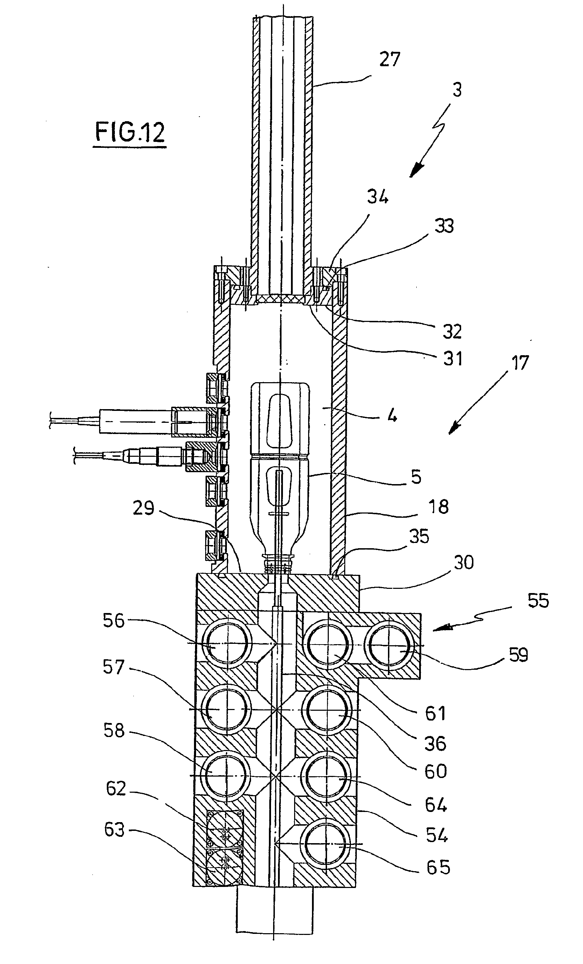

Fig. 12 zeigt im Detail einen unterhalb des Kammersockels (30) angeordneten Ventilblock (54). Der Ventilblock (54) besteht im wesentlichen aus einem Blockgehäuse, das eine Mehrzahl von Ventilen (55) haltert. Insbesondere ist daran gedacht, elektromagnetisch gesteuerte Ventile (55) zu verwenden.

Beim Ausführungsbeispiel gemäß Fig. 12 ist der Ventilblock (54) unmittelbar unterhalb des Kammersockels (30) angeordnet. Grundsätzlich ist es ebenfalls denkbar, den Kammersokkel (30) und den Ventilblock (54) als ein einheitliches Bauteil zu realisieren. Die Ventile (55) sind in Fig. 12 lediglich schematisch dargestellt. Insbesondere weist der Ventilblock (54) gemäß der vorliegenden Ausführungsform ein Primärvakuumventil (56) zur Zuführung einer ersten Unterdruckstufe sowie ein Sekundärvakuumventil (57) zur Zuführung eines gegenüber der ersten Unterdruckstufe niedrigeren Unterdruckes auf. Zur Aufrechterhaltung des Vakuums synchron zur Zuführung des Prozeßgases ist darüber hinaus ein Prozeßvakuumventil (58) angeordnet. Das Prozeßvakuumventil (58) vermeidet einen Übertritt von abgesaugtem Prozeßgas in die Versorgungskreise für das Primärvakuum und das Sekundärvakuum.

Zur Unterstützung einer wahlweisen oder gemeinsamen Zuführung von Unterdruck zum Innenraum des Werkstückes (5) und / oder in den weiteren Innenraum der Plasmakammer (17) ist ein Kammervakuumventil (59) verwendet, das eine entsprechende Absperrfunktion durchführt. Insbesondere ist daran gedacht, das jeweilige Versorgungsvakuum über die Ventile (56, 57, 58) jeweils unmittelbar dem Innenraum des Werkstückes (5) zuzuführen und über das Kammervakuumventil (59) gesteuert eine bedarfsabhängige Zuschaltung des weiteren Innenraumes der Plasmakammer (17) vorzunehmen.

Zur Unterstützung einer vorgebbaren und voneinander unabhängigen Entlüftung sowohl des Innenraumes des Werkstückes (5) als auch des weiteren Innenraumes der Plasmakammer (17) sind ein Werkstückentlüftungsventil (60) sowie ein Kammerentlüftungsventil (61) verwendet.

Zur Unterstützung einer Zuführung unterschiedlicher Prozeßgaszusammensetzungen sind ein Primärprozeßgasventil (62) sowie ein Sekundärprozeßgasventil (63) verwendet. Über Zusatzventile (64, 65) ist eine Zuschaltung oder Ableitung weiterer Betriebsmittel möglich.

Bei der in Fig. 12 dargestellten Ausführungsform sind jeweils gruppenartig eine Mehrzahl von Ventilen untereinander angeordnet. Eine derartige Anordnung unterstützt einen Anschluß der Ventile an die entsprechenden Betriebsmittelquellen. Ebenfalls erleichtert eine derartige Anordnung den elektrischen Anschluß von elektromagnetisch gesteuerten Ventilen.

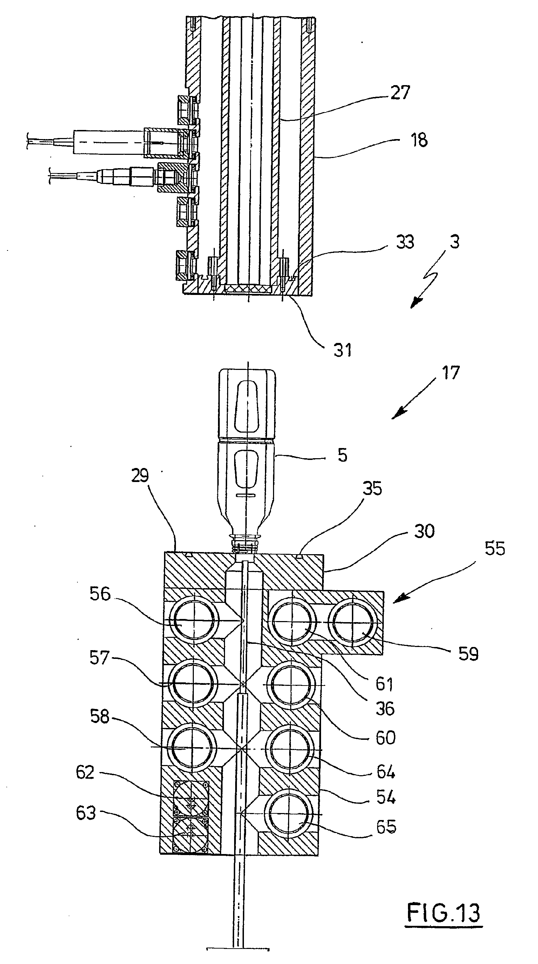

Fig. 13 zeigt die Anordnung gemäß Fig. 12 nach einem Öffnen der Plasmakammer (17) durch Anheben der Kammerwandung (18). In diesem Betriebszustand der Plasmastation (3) sind sämtliche Ventile (55) geschlossen und die Lanze (36) ist in den Kammersockel (30) und den Ventilblock (54) hinein zurückgezogen, so daß eine seitliche Positionierbarkeit des Werkstückes (5) ermöglicht ist.

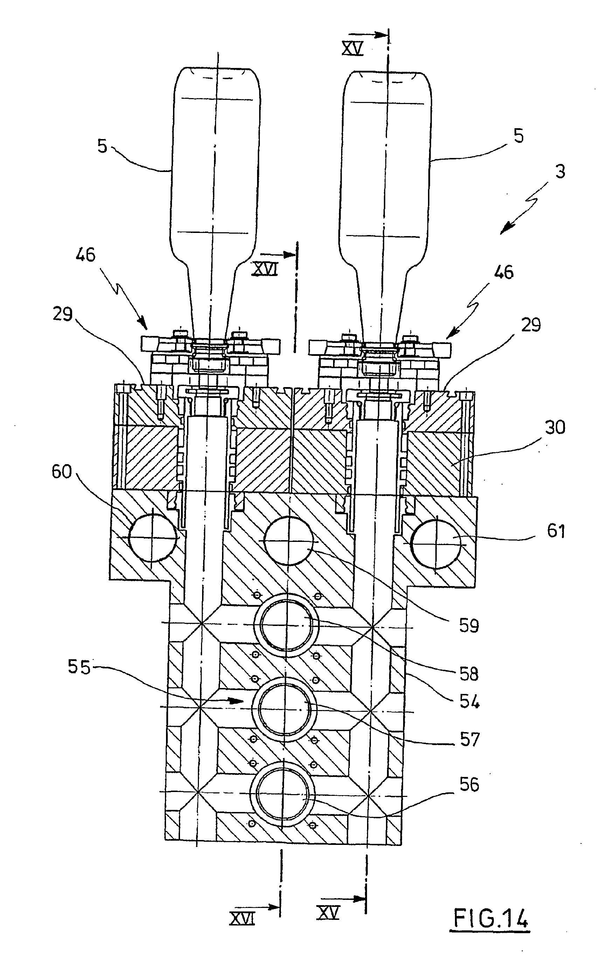

Fig. 14 zeigt eine gegenüber Fig. 12 und Fig. 13 abgewandelte Ausführungsform des Ventilblockes (54). Die hier dargestellte Ausführungsform ist insbesondere für eine Versorgung von zwei Plasmakammern (17) bei möglichst symmetrischer Gestaltung der jeweiligen Zuführkanäle vorteilhaft. Die Prozeßgasventile (62, 63) sind bei den Darstellungen von Fig. 14 bis Fig. 16 nicht mit abgebildet.

In einem der Plasmakammer (17) zugewandten Bereich des Ventilblockes (54) sind auf einer im Wesentlichen gleichen vertikalen Ebene das Kammervakuumventil (59), das Werkstückentlüftungsventil (60) sowie das Kammerentlüftungsventil (61) angeordnet. Unterhalb dieser Ebene und in vertikaler Richtung untereinander sind das Primärvakuumventil (56), das Sekundärvakuumventil (57) sowie das Prozeßvakuumventil (58) angeordnet.

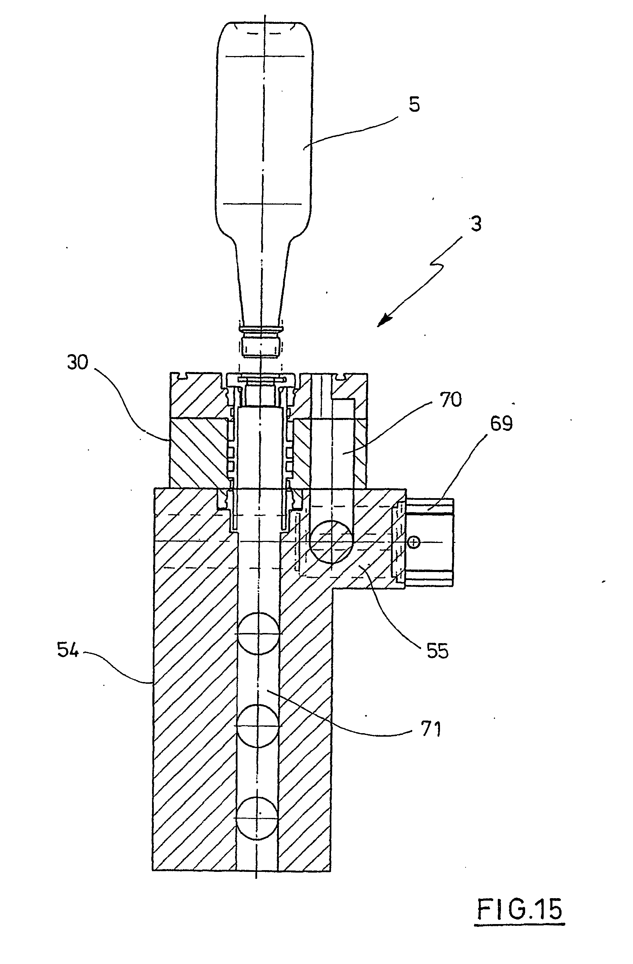

Fig. 15 zeigt in einer weiteren Vertikalschnittdarstellung, daß für eine Ansteuerung der Ventile (55) jeweils Stellelemente (69) verwendet sind. Die Stellelemente (69) können beispielsweise als elektromagnetische Spulen ausgebildet sein, die in Abhängigkeit von ihrer jeweiligen elektrischen Ansteuerung die Ventile (55) in einer geschlossenen Positionierung, einer geöffneten Positionierung oder gegebenenfalls auch in Zwischenpositionierungen anordnen. Innerhalb des Ventilblockes (54) verläuft ein Kammeranschlußkanal (70) für eine unmittelbare Verbindung mindestens eines der Ventile (55) mit dem Innenraum der Plasmakammer (17) sowie ein Werkstückanschlußkanal (71) zur Verbindung mindestens eines der Ventile (55) mit einem Innenraum des zu behandelnden Werkstückes (5).

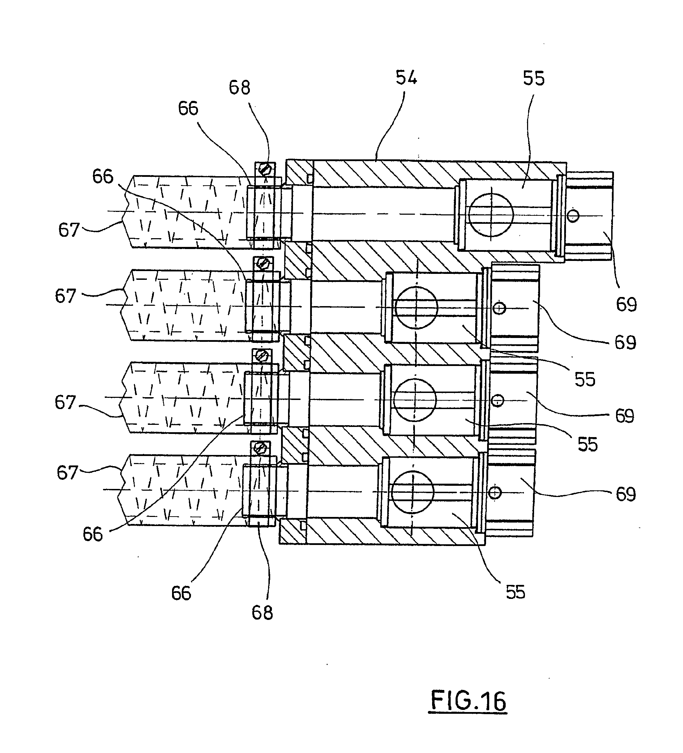

Fig. 16 zeigt einen Anschluß der Ventile (55). Es sind hier auf Anschlußstutzen (66) flexible Verbindungsleitungen (67) aufgesteckt und mit Schlauchschellen (68) fixiert. Ebenfalls ist eine Verwendung von Verbindungsrohren möglich. Die jeweilige Auswahl der geeigneten Verbindungsleitungen (67) erfolgt unter Berücksichtigung der konstruktiven Randbedingungen.

Ein typischer Behandlungsvorgang wird im folgenden am Beispiel eines Beschichtungsvorganges erläutert und derart durchgeführt, daß zunächst das Werkstück (5) unter Verwendung des Eingaberades (11) zum Plasmarad (2) transportiert wird und daß in einem hochgeschobenen Zustand der hülsenartigen Kammerwandung (18) das Einsetzen des Werkstückes (5) in die Plasmastation (3) erfolgt. Nach einem Abschluß des Einsetzvorganges wird die Kammerwandung (18) in ihre abgedichtete Positionierung abgesenkt und zunächst gleichzeitig eine Evakuierung sowohl der Kavität (4) als auch eines Innenraumes des Werkstückes (5) durchgeführt.

Nach einer ausreichenden Evakuierung des Innenraumes der Kavität (4) wird die Lanze (36) in den Innenraum des Werkstückes (5) eingefahren und durch eine Verschiebung des Dichtelementes (28) eine Abschottung des Innenraumes des Werkstückes (5) gegenüber dem Innenraum der Kavität (4) durchgeführt. Ebenfalls ist es möglich, die Lanze (36) bereits synchron zur beginnenden Evakuierung des Innenraumes der Kavität in das Werkstück (5) hinein zu verfahren. Der Druck im Innenraum des Werkstückes (5) wird anschließend noch weiter abgesenkt. Darüber hinaus ist auch daran gedacht, die Positionierbewegung der Lanze (36) wenigstens teilweise bereits parallel zur Positionierung der Kammerwandung (18) durchzuführen. Nach Erreichen eines ausreichend tiefen Unterdruckes wird Prozeßgas in den Innenraum des Werkstückes (5) eingeleitet und mit Hilfe des Mikrowellengenerators (19) das Plasma gezündet. Insbesondere ist daran gedacht, mit Hilfe des Plasmas sowohl einen Haftvermittler auf eine innere Oberfläche des Werkstückes (5) als auch die eigentliche Barriereschicht aus Siliziumoxiden abzuscheiden.

Nach einem Abschluß des Beschichtungsvorganges wird die Lanze (36) wieder aus dem Innenraum des Werkstückes (5) entfernt und die Plasmakammer (17) sowie der Innenraum des Werkstückes (5) werden belüftet. Nach Erreichen des Umgebungsdruckes innerhalb der Kavität (4) wird die Kammerwandung (18) wieder angehoben, um eine Entnahme des beschichteten Werkstückes (5) sowie eine Eingabe eines neuen zu beschichtenden Werkstückes (5) durchzuführen. Zur Ermöglichung einer seitlichen Positionierung des Werkstückes (5) wird das Dichtelement (28) mindestens bereichsweise wieder in den Kammersockel (3) hinein verfahren.

Alternativ zur erläuterten Innenbeschichtung von Werkstükken (5) können auch Außenbeschichtungen, Sterilisationen oder Oberflächenaktivierungen durchgeführt werden.

Eine Positionierung der Kammerwandung (18), des Dichtelementes (28) und / oder der Lanze (36) kann unter Verwendung unterschiedlicher Antriebsaggregate erfolgen. Grundsätzlich ist die Verwendung pneumatischer Antriebe und / oder elektrischer Antriebe, insbesondere in einer Ausführungsform als Linearmotor, denkbar. Insbesondere ist aber daran gedacht, zur Unterstützung einer exakten Bewegungskoordinierung mit einer Rotation des Plasmarades (2) eine Kurvensteuerung zu realisieren. Die Kurvensteuerung kann beispielsweise derart ausgeführt sein, daß entlang eines Umfanges des Plasmarades (2) Steuerkurven angeordnet sind, entlang derer Kurvenrollen geführt werden. Die Kurvenrollen sind mit den jeweils zu positionierenden Bauelementen gekoppelt.

Die Betätigung der Ventile (55) erfolgt vorzugsweise über eine programmierbare elektronische Steuerung. Zunächst wird nach einem Schließen der Plasmakammer (17) das Primärvakuumventil (56) geöffnet und der Innenraum des Werkstückes (5) und der Innenraum der Plasmakammer (17) gleichzeitig evakuiert. Hierbei wird ein Druckniveau im Bereich von 20 mbar bis 50 mbar erreicht. Nach einem Schließen des Primärvakuumventils (56) erfolgt ein Öffnen des Sekundärvakuumventils (57) und der Innenraum des Werkstückes (5) und der Innenraum der Plasmakammer (17) werden zunächst gleichzeitig an eine Unterdruckquelle mit einem niedrigeren Druckniveau angeschlossen. Nach einer ausreichenden Evakuierung des das Werkstück (5) umgebenden Innenraumes der Plasmakammer (17) schließt das Kammervakuumventil (59) und lediglich der Innenraum des Werkstückes (5) wird weiter evakuiert. Hierbei wird ein Druckniveau von etwa 0,1 mbar erreicht.

Nach einem Schließen des Kammervakuumventils (59) und einer in der Regel bereits zuvor erfolgten Positionierung der Lanze (36) innerhalb des Innenraumes des Werkstückes (5) öffnet das Primärprozeßgasventil (62) und ein Prozeßgas einer ersten Zusammensetzung wird zugeführt. Zur Prozeßgasversorgung der Lanze (36) ist insbesondere daran gedacht, die beispielsweise in Fig. 6 dargestellten Gasanschlüsse (39) im Bereich des Kammersockels (30) derart auszuführen, daß innerhalb einer bohrungsartigen Ausnehmung ein rohrartiges Kupplungselement in einer Längsrichtung verschieblich geführt ist. Eine Abdichtung kann über eine dynamische Ringdichtung erfolgen. Das rohrartige Verbindungselement ist vom Lanzenschlitten (37) getragen und stellt eine Verbindung zum Plasmagaskanal (38) innerhalb des Lanzenschlittens (37) her. Durch eine entsprechende Verschiebung des rohrartigen Verbindungselementes innerhalb der bohrungsartigen Ausnehmung ist für jede Positionierung des Lanzenschlittens (37) eine Verbindung mit der Prozeßgasverteilung gewährleistet.

Nach einer ausreichenden Prozeßgaszuführung zündet der Mikrowellengenerator (19) das Plasma im Innenraum des Werkstückes (5). Zu einem vorgebbaren Zeitpunkt schließt das Primärprozeßgasventil (62) und das Sekundärprozeßgasventil (63) öffnet zur Zuführung eines Prozeßgases einer zweiten Zusammensetzung. Zumindest zeitweise parallel zum Öffnen der Prozeßgasventile (62, 63) öffnet auch das Prozeßvakuumventil (58), um einen ausreichend niedrigen Unterdruck im Innenraum des Werkstückes (5) aufrecht zu erhalten. Hierbei erweist sich ein Druckniveau von etwa 0,3 mbar als zweckmäßig.

Nach einem Abschluß der Plasmabeschichtung öffnet zunächst das Werkstückentlüftungsventil (60) und schließt den Innenraum des Werkstückes (5) an einen Umgebungsdruck an. Mit einer vorgebbaren zeitlichen Verzögerung nach einem Öffnen des Werkstückentlüftungsventils (60) öffnet auch das Kammerentlüftungsventil (61), um den Innenraum der Plasmakammer (17) wieder vollständig auf den Umgebungsdruck anzuheben. Nach einem zumindest annäherungsweise Erreichen des Umgebungsdruckes innerhalb der Plasmakammer (17) kann die Plasmakammer (17) öffnen und das beschichtete Werkstück (5) wird entnommen und durch ein neues zu beschichtendes Werkstück (5) ersetzt.

Zur Entfernung eventueller Rückstände des Plasmabehandlungsverfahrens innerhalb des Werkstückes (5) ist es möglich, vor einer Entnahme des Werkstückes (5) aus der Plasmakammer (17) Druckluft in das Werkstück (5) einzubringen und hierdurch die eventuellen Verunreinigungen zu entfernen. Die Ableitung der Druckluft kann entweder in eine Umgebung der Plasmastation (3) erfolgen, insbesondere ist aber auch daran gedacht, gleichzeitig zur Druckbeaufschlagung auch einen der Unterdruckanschlüsse zu aktivieren und hierdurch ein definiertes Absaugen der Verunreinigungen durchzuführen. Alternativ ist ebenfalls daran gedacht, den Reinigungsvorgang ausschließlich durch eine zusätzliche Unterdruckbeaufschlagung durchzuführen und den Reinigungsvorgang durch nachströmende Umgebungsluft durchzuführen.
Bei einer Druckluftzuführung ist insbesondere an eine Zuführung durch die Lanze (36) hindurch gedacht, da hierdurch die Spülluft in einen Bereich des Innenraumes des Werkstükkes (5) eingebracht werden kann, der einer Öffnung des Werkstückes (5) abgewandt angeordnet ist. Hierdurch wird eine Spülluftströmung in Richtung auf die Öffnung des Werkstückes (5) unterstützt und ein wirksamer Reinigungsvorgang durchgeführt.

## Patentansprüche

1. Verfahren zur Plasmabehandlung von Werkstücken (5), bei dem das Werkstück (5) in eine zumindest teilweise evakuierbare Kammer einer Behandlungsstation eingesetzt wird und bei dem das Werkstück (5) innerhalb der Behandlungsstation von einem Halteelement (46) positioniert wird, sowie bei dem ein Anschluß der Kammer an mindestens eine Betriebsmittelversorgung von einem in der Nähe eines Kammerbodens (29) angeordneten Ventilblock (55) mit mindestens zwei Ventilen (56) gesteuert wird, **dadurch gekennzeichnet, daß** ein Innenraum eines hohlkörperartigen Werkstückes (5) behandelt wird, daß die mindestens eine Plasmastation (3) von einem rotierenden Plasmarad (2) von einer Eingabepositionierung in eine Ausgabepositionierung überführt wird, daß von einer Plasmastation (3) mehrere Kavitäten (4) bereitgestellt werden und daß von einem Primärvakuumventil (56) des Ventilblockes (54) ein erster Unterdruck und von einem Sekundärvakuumventil (57) des Ventilblockes (54) ein relativ zum ersten Unterdruck niedrigerer zweiter Unterdruck zugeschaltet wird, wobei der Ventilblock (54) als Teil des Kammersockels (30) angeordnet wird.

2. Verfahren nach Anspruch 1, **dadurch gekennzeichnet, daß** über mindestens eines der Ventile (55) ein Unterdruck gesteuert wird.

3. Verfahren nach Anspruch 1 oder 2, **dadurch gekennzeichnet, daß** mindestens zwei Ventile (55) zur Zuschaltung von mindestens zwei unterschiedlichen Unterdruckstufen verwendet werden.

4. Verfahren nach einem der Ansprüche 1 bis 3, **dadurch gekennzeichnet, daß** eine Evakuierung einer Kavität (4) der Plasmastation (3) durch den Kammerboden (29) hindurch erfolgt.

5. Verfahren nach einem der Ansprüche 1 bis 4, **dadurch gekennzeichnet, daß** durch den Kammerboden (29) hindurch Prozeßgas zugeführt wird.

6. Verfahren nach einem der Ansprüche 1 bis 5, **dadurch gekennzeichnet, daß** das Prozeßgas durch eine Lanze (36) hindurch in einen Innenraum des Werkstückes (5) zugeführt wird.

7. Verfahren nach einem der Ansprüche 1 bis 6, **dadurch gekennzeichnet, daß** über ein Primärvakuumventil (56) eine erste Unterdruckstufe zugeführt wird.

8. Verfahren nach einem der Ansprüche 1 bis 7, **dadurch gekennzeichnet, daß** ein Innenraum des Werkstückes (5) und ein weiterer Innenraum der Behandlungsstation mindestens zeitweilig gleichzeitig an die Unterdruckversorgung angeschlossen werden.

9. Verfahren nach einem der Ansprüche 1 bis 8, **dadurch gekennzeichnet, daß** der Innenraum des Werkstückes (5) und der weitere Innenraum der Plasmakammer (17) mindestens zeitweilig gleichzeitig an eine Unterdruckversorgung mit einem gegenüber der ersten Unterdruckversorgung niedrigeren Druck angeschlossen werden.

10. Verfahren nach einem der Ansprüche 1 bis 9, **dadurch gekennzeichnet, daß** der Innenraum des Werkstückes (5) für einen längeren Zeitraum an mindestens eine der Unterdruckversorgungen angeschlossen wird.

11. Verfahren nach einem der Ansprüche 1 bis 10, **dadurch gekennzeichnet, daß** mindestens ein Teilbereich der Plasmakammer (17) zeitweilig über den Ventilblock (54) an einen Umgebungsdruck angeschlossen wird.

12. Verfahren nach einem der Ansprüche 1 bis 10, **dadurch gekennzeichnet, daß** mindestens ein Teilbereich des Innenraumes des Werkstückes (5) zeitweilig über den Ventilblock (54) an einen Umgebungsdruck angeschlossen wird.

13. Verfahren nach einem der Ansprüche 1 bis 12, **dadurch gekennzeichnet, daß** im Bereich des Kammerdeckels (31) von einem Mikrowellengenerator (19) erzeugte Mikrowellen in die Kavität (4) eingeleitet werden.

14. Verfahren nach einem der Ansprüche 1 bis 13, **dadurch gekennzeichnet, daß** ein Werkstück (5) aus einem thermoplastischen Kunststoff behandelt wird.

15. Verfahren nach einem der Ansprüche 1 bis 14, **dadurch gekennzeichnet, daß** als Werkstück (5) ein Behälter behandelt wird.

16. Verfahren nach einem der Ansprüche 1 bis 15, **dadurch gekennzeichnet, daß** als Werkstück (5) eine Getränkeflasche behandelt wird.

17. Verfahren nach einem der Ansprüche 1 bis 16, **dadurch gekennzeichnet, daß** Plasmagas mindestens einer vorgebbaren Zusammensetzung über mindestens ein Prozeßgasventil (62, 63) mit einer Betriebsmittelversorgung verbunden wird.

18. Verfahren nach einem der Ansprüche 1 bis 17, **dadurch gekennzeichnet, daß** als Plasmabehandlung eine Plasmabeschichtung durchgeführt wird.

19. Verfahren nach einem der Ansprüche 1 bis 18, **dadurch gekennzeichnet, daß** die Plasmabehandlung unter Verwendung eines Niederdruckplasmas durchgeführt wird.

20. Verfahren nach einem der Ansprüche 1 bis 19, **dadurch gekennzeichnet, daß** eine Plasmapolymerisation durchgeführt wird.

21. Verfahren nach einem der Ansprüche 1 bis 20, **dadurch gekennzeichnet, daß** durch das Plasma mindestens zum Teil organische Substanzen abgeschieden werden.

22. Verfahren nach einem der Ansprüche 1 bis 20, **dadurch gekennzeichnet, daß** durch das Plasma mindestens zum Teil anorganische Substanzen abgeschieden werden.

23. Verfahren nach einem der Ansprüche 1 bis 22, **dadurch gekennzeichnet, daß** durch das Plasma eine Substanz zur Verbesserung von Barriereeigenschaften des Werkstückes (5) abgeschieden wird.

24. Verfahren nach Anspruch 23, **dadurch gekennzeichnet, daß** zusätzlich ein Haftvermittler zur Verbesserung eines Anhaftens der Substanz auf einer Oberfläche des Werkstückes (5) abgeschieden wird.

25. Verfahren nach einem der Ansprüche 1 bis 24, **dadurch gekennzeichnet, daß** in einer gemeinsamen Kavität mindestens zwei Werkstücke (5) gleichzeitig behandelt werden.

26. Verfahren nach einem der Ansprüche 1 bis 17, **dadurch gekennzeichnet, daß** als Plasmabehandlung eine Plasmasterilisation durchgeführt wird.

27. Verfahren nach einem der Ansprüche 1 bis 17, **dadurch gekennzeichnet, daß** als Plasmabehandlung eine Oberflächenaktivierung des Werkstückes (5) durchgeführt wird.

28. Vorrichtung zur Plasmabehandlung von Werkstücken (5), die mindestens eine evakuierbare Plasmakammer (17) zur Aufnahme der Werkstückle (5) aufweist und bei der die Plasma-kammer (17) im Bereich einer Behandlungsstation angeordnet ist, sowie bei der die Plasma-kammer (17) von einem Kammerboden (29), einem Kammerdeckel (31) sowie einer seitlichen Kammerwandung (18) begrenzt ist und mindestens ein Halteelement (46) zur Positionierung des Werkstückes aufweist, sowie bei der in einem der Plasmakammer (17) abgewandt angeordneten Bereich des Kammerbodens (29) ein Ventilblock (54) mit mindestens zwei Ventilen (56) zur Steuerung eines Anschlusses der Plasmakammer (17) an mindestens eine Betriebsmittelversorgung angeordnet ist, **dadurch gekennzeichnet, dass** der Ventilblock (54) ein Primärvakuumventil (56) zur Zuschaltung eines ersten Unterdruckes aufweist, dass der Ventilblock (54) ein Sekundärvakuumventil (57) zur Zuschaltung eines relativ zum ersten Unterdruck niedrigeren Unterdruckes aufweist, dass die Plasmastation (3) zur Beschichtung eines Innenraumes eines hohlkörperartigen Werkstückes (5) ausgebildet ist, dass die mindestens eine Plasmastation (3) von einem rotierenden Plasmarad (2) getragen ist, dass im Bereich der Plasmastation (3) mehrere Kavitäten (4) angeordnet sind, dass der Ventilblock (54) Teil des Kammersockels (30) ist.

29. Vorrichtung nach Anspruch 28, **dadurch gekennzeichnet, daß** mindestens eines der Ventile (55) zur Zuschaltung von Unterdruck ausgebildet ist.

30. Vorrichtung nach Anspruch 28 oder 29, **dadurch gekennzeichnet, daß** der Ventilblock (54) zur Zuschaltung von mindestens zwei unterschiedlichen Unterdrücken ausgebildet ist.

31. Vorrichtung nach einem der Ansprüche 28 bis 30, **dadurch gekennzeichnet, daß** für eine Evakuierung einer Kavität (4) der Plasmastation (3) im Kammerboden (29) mindestens ein Vakuumkanal angeordnet ist.

32. Vorrichtung nach einem der Ansprüche 28 bis 31, **dadurch gekennzeichnet, daß** im Kammerboden (29) mindestens ein Kanal zur Zuführung von Prozeßgas angeordnet ist.

33. Vorrichtung nach einem der Ansprüche 28 bis 32, **dadurch gekennzeichnet, daß** zur Zuführung von Prozeßgas in einen Innenraum des Werkstückes (5) hinein eine Lanze (36) relativ zum Kammerboden (29) positionierbar angeordnet ist.

34. Vorrichtung nach Anspruch 28, **dadurch gekennzeichnet, daß** das Primärvakuumventil (56) mindestens zeitweilig sowohl einen Innenraum des Werkstückes (5) als auch einen weiteren Innenraum der Plasmakammer (17) an eine gemeinsame Unterdruckversorgung anschließt.

35. Vorrichtung nach Anspruch 28, **dadurch gekennzeichnet, daß** das Sekundärvakuumventil (57) mindestens zeitweilig ausschließlich einen Innenraum des Werkstückes (5) mit der Unterdruckquelle verbindet.

36. Vorrichtung nach einem der Ansprüche 28 bis 35, **dadurch gekennzeichnet, daß** der Ventilblock (54) ein Werkstückentlüftungsventil (60) zur Verbindung eines Innenraumes des Werkstückes (5) mit einem Umgebungsdruck aufweist.

37. Vorrichtung nach einem der Ansprüche 28 bis 36, **dadurch gekennzeichnet, daß** der Ventilblock (54) ein Kammerentlüftungsventil (61) zur Verbindung eines Innenraumes der Plasmakammer (17) mit einem Umgebungsdruck aufweist.

38. Vorrichtung nach einem der Ansprüche 28 bis 37, **dadurch gekennzeichnet, daß** im Bereich des Kammerdeckels (31) ein Mikrowellengenerator (19) angeordnet ist.

39. Vorrichtung nach einem der Ansprüche 28 bis 38, **dadurch gekennzeichnet, daß** die Plasmastation (3) zur Beschichtung eines Werkstückes (5) aus einem thermoplastischen Kunststoff ausgebildet ist.

40. Vorrichtung nach einem der Ansprüche 28 bis 39, **dadurch gekennzeichnet, daß** die Plasmastation (3) zur Beschichtung eines behälterartigen Werkstückes (5) ausgebildet ist.

41. Vorrichtung nach einem der Ansprüche 28 bis 40, **dadurch gekennzeichnet, daß** die Plasmastation (3) zur Beschichtung eines Werkstückes (5) in Form einer Getränkeflasche ausgebildet ist.

42. Vorrichtung nach einem der Ansprüche 28 bis 41, **dadurch gekennzeichnet, daß** eine zur Bereitstellung von mindestens zwei Kavitäten (4) vorgesehene Kammerwandung (18) positionierbar angeordnet ist.

43. Vorrichtung nach einem der Ansprüche 28 bis 42, **dadurch gekennzeichnet, daß** der Ventilblock (54) mindestens ein Prozeßgasventil (62, 63) aufweist.

44. Vorrichtung nach einem der Ansprüche 28 bis 43, **dadurch gekennzeichnet, daß** der Ventilblock (54) in lotrechter Richtung unterhalb des Kammerbodens (29) angeordnet ist.

45. Vorrichtung nach einem der Ansprüche 28 bis 43, **dadurch gekennzeichnet, daß** der Ventilblock (54) im Wesentlichen neben dem Kammersockel (30) angeordnet ist.

46. Vorrichtung nach einem der Ansprüche 28 bis 45, **dadurch gekennzeichnet, daß** mindestens eines der Prozeßgasventile (62, 63) an ein in lotrechter Richtung nach unten weisendes Kupplungselement angeschlossen ist.

47. Vorrichtung nach Anspruch 46, **dadurch gekennzeichnet, daß** das Kupplungselement als Verbindung zu einem die Lanze (36) tragenden Lanzenschlitten (37) ausgebildet ist.

48. Vorrichtung nach Anspruch 46 oder 47, **dadurch gekennzeichnet, daß** im Bereich des Lanzenschlittens (37) ein Umlenkungskanal für das Plasmagas angeordnet ist, der das Plasmagas vom Kupplungselement in Richtung auf die Lanze (36) leitet.

49. Vorrichtung nach einem der Ansprüche 28 bis 48, **dadurch gekennzeichnet, daß** mindestens eines der Ventile (55) als ein elektromagnetisch gesteuertes Ventil ausgebildet ist.

## Claims

1. A method for plasma treating workpieces (5), in the case of which the workpiece (5) is inserted into an at least partially evacuatable chamber of a treatment station and in the case of which the workpiece (5) is positioned by a holding element (46) within the treatment station, and in the case of which a connection of the chamber to at least one operating means supply is controlled by a valve block (55), which is arranged in the vicinity of a chamber bottom (29) and which comprises at least two valves (56), **characterised in that** an interior of a hollow body-like workpiece (5) is treated, that the at least one plasma station (3) is transferred from an input positioning into an output positioning by means of a rotating plasma wheel (2), that a plasma station (3) provides for a plurality of cavities (4) and that a first low pressure is connected by a primary vacuum valve (56) of the valve block (54) and a second low pressure , which is lower as compared to the first low pressure, is connected by a secondary vacuum valve (57) of the valve block (54), wherein the valve block (54) is arranged as part of the chamber base (30).

2. The method according to claim 1, **characterised in that** a low pressure is controlled via at least one of the valves (55).

3. The method according to claim 1 or 2, **characterised in that** at least two valves (55) are used to connect at least two different low pressure stages.

4. The method according to any one of claims 1 to 3, **characterised in that** an evacuation of a cavity (4) of the plasma station (3) takes place through the chamber bottom (29).

5. The method according to any one of claims 1 to 4, **characterised in that** process gas is supplied through the chamber bottom (29).

6. The method according to any one of claims 1 to 5, **characterised in that** the process gas is supplied through a lance (36) into an interior of the workpiece (5).

7. The method according to any one of claims 1 to 6, **characterised in that** a first low pressure stage is supplied via a primary vacuum valve (56).

8. The method according to any one of claims 1 to 7, **characterised in that** an interior of the workpiece (5) and a further interior of the treatment station are simultaneously connected at least temporarily to the low pressure supply.

9. The method according to any one of claims 1 to 8, **characterised in that** the interior of the workpiece (5) and the further interior of the plasma chamber (17) are simultaneously connected at least temporarily to a low pressure supply comprising a pressure, which is lower as compared to the first low pressure supply.

10. The method according to any one of claims 1 to 9, **characterised in that** the interior of the workpiece (5) is connected to at least one of the low pressure supplies for a longer period of time.

11. The method according to any one of claims 1 to 10, **characterised in that** at least a partial area of the plasma chamber (17) is temporarily connected to an ambient pressure via the valve block (54).

12. The method according to any one of claims 1 to 10, **characterised in that** at least a partial area of the interior of the workpiece (5) is temporarily connected to an ambient pressure via the valve block (54).

13. The method according to any one of claims 1 to 12, **characterised in that** microwaves, which are generated by a microwave generator (19) in the area of the chamber lid (31), are introduced into the cavity (4).

14. The method according to any one of claims 1 to 13, **characterised in that** a workpiece (5) made from a thermoplastic plastic is treated.

15. The method according to any one of claims 1 to 14, **characterised in that** a container is treated as workpiece (5).

16. The method according to any one of claims 1 to 15, **characterised in that** a beverage bottle is treated as workpiece (5).

17. The method according to any one of claims 1 to 16, **characterised in that** plasma gas of at least a predeterminable composition is connected to an operating means supply via at least one process gas valve (62, 63).

18. The method according to any one of claims 1 to 17, **characterised in that** a plasma coating is carried out as plasma treatment.

19. The method according to any one of claims 1 to 18, **characterised in that** the plasma treatment is carried out by using a low pressure plasma.

20. The method according to any one of claims 1 to 19, **characterised in that** a plasma polymerisation is carried out.

21. The method according to any one of claims 1 to 20, **characterised in that** organic substances are at least partially separated through the plasma.

22. The method according to any one of claims 1 to 20, **characterised in that** inorganic substances are at least partially separated through the plasma.

23. The method according to any one of claims 1 to 22, **characterised in that** a substance for improving barrier characteristics of the workpiece (5) is separated through the plasma.

24. The method according to claim 23, **characterised in that** an adhesive agent for improving an adhesion of the substance on a surface of the workpiece (5) is separated additionally.

25. The method according to any one of claims 1 to 24, **characterised in that** at least two workpieces (5) are treated simultaneously in a common cavity.

26. The method according to any one of claims 1 to 17, **characterised in that** a plasma sterilisation is carried out as plasma treatment.

27. The method according to any one of claims 1 to 17, **characterised in that** a surface activation of the workpiece (5) is carried out as plasma treatment.

28. A device for plasma treating workpieces (5), which encompasses at least one evacuatable plasma chamber (17) for accommodating the workpieces (5) and in the case of which the plasma chamber (17) is arranged in the area of a treatment station, and in the case of which the plasma chamber (17) is delimited by a chamber bottom (29), a chamber lid (31) as well as a lateral chamber wall (18) and encompasses at least one holding element (46) for positioning the workpiece, and in the case of which a valve block (54) comprising at least two valves (56) for controlling a connection of the plasma chamber (17) to at least one operating means supply is arranged in an area of the chamber bottom (29), which is arranged so as to face away from the plasma chamber (17), **characterised in that** the valve block (54) encompasses a primary vacuum valve (56) for connecting a first low pressure, that the valve block (54) encompasses a secondary vacuum valve (57) for connecting a low pressure, which is lower as compared to the first low pressure, that the plasma station (3) is embodied to coat an interior of a hollow body-like workpiece (5), that the at least one plasma station (3) is supported by a rotating plasma wheel (2), that a plurality of cavities (4) are arranged in the area of the plasma station (3), that the valve block (54) is part of the chamber base (30).

29. The device according to claim 28, **characterised in that** at least one of the valves (55) is embodied to connect low pressure.

30. The device according to claim 28 or 29, **characterised in that** the valve block (54) is embodied to connect at least two different low pressures.

31. The device according to any one of claims 28 to 30, **characterised in that** at least one vacuum channel is arranged in the chamber bottom (29) for an evacuation of a cavity (4) of the plasma station (3).

32. The device according to any one of claims 28 to 31, **characterised in that** at least one channel for supplying process gas is arranged in the chamber bottom (29).

33. The device according to any one of claims 28 to 32, **characterised in that** a lance (36) is arranged so as to be capable of being positioned relative to the chamber bottom (29) for supplying process gas into an interior of the workpiece (5).

34. The device according to claim 28, **characterised in that** the primary vacuum valve (56) at least temporarily connects both an interior of the workpiece (5) as well as a further interior of the plasma chamber (17) to a common low pressure supply.

35. The device according to claim 28, **characterised in that** the secondary vacuum valve (57) at least temporarily connects only an interior of the workpiece (5) to the low pressure source.

36. The device according to any one of claims 28 to 35, **characterised in that** the valve block (54) encompasses a workpiece ventilation valve (60) for connecting an interior of the workpiece (5) to an ambient pressure.

37. The device according to any one of claims 28 to 36, **characterised in that** the valve block (54) encompasses a chamber ventilation valve (61) for connecting an interior of the plasma chamber (17) to an ambient pressure.

38. The device according to any one of claims 28 to 37, **characterised in that** a microwave generator (19) is arranged in the area of the chamber lid (31).

39. The device according to any one of claims 28 to 38, **characterised in that** the plasma station (3) for coating a workpiece (5) is embodied from a thermoplastic plastic.

40. The device according to any one of claims 28 to 39, **characterised in that** the plasma station (3) is embodied to coat a container-like workpiece (5).

41. The device according to any one of claims 28 to 30, **characterised in that** the plasma station (3) is embodied to coat a workpiece (5) in the form of a beverage bottle.

42. The device according to any one of claims 28 to 41, **characterised in that** a chamber wall (18), which is provided to provide at least two cavities (4), is arranged so as to be capable of being positioned.

43. The device according to any one of claims 28 to 42, **characterised in that** the valve block (54) encompasses at least one process gas valve (62, 63).

44. The device according to any one of claims 28 to 43, **characterised in that** the valve block (54) is arranged below the chamber bottom (29) in vertical direction.

45. The device according to any one of claims 28 to 43, **characterised in that** the valve block is arranged substantially next to the chamber base (30).

46. The device according to any one of claims 28 to 45, **characterised in that** at least one of the process gas valves (62, 63) is connected to a coupling element, which points downwards in vertical direction.

47. The device according to claim 46, **characterised in that** the coupling element is embodied as connection to a lance carriage (37), which supports the lance (36).

48. The device according to claim 46 or 47, **characterised in that** a deflection channel for the plasma gas, which guides the plasma gas from the coupling element in the direction towards the lance (36), is arranged in the area of the lance carriage (37).

49. The device according to any one of claims 28 to 48, **characterised in that** at least one of the valves (55) is embodied as an electromagnetically controlled valve.

## Revendications

1. Procédé de traitement au plasma de pièces (5) dans le cadre duquel la pièce (5) est introduite dans une chambre d'une station de traitement pouvant, en partie au moins, être évacuée, et est positionnée par un élément de maintien 46 à l'intérieur de la station de traitement, et dans le cadre duquel un raccordement de la chambre à au moins un dispositif d'alimentation en moyens de production est commandé par un bloc de vannes (55) placé à proximité du fond (29) de la chambre et muni d'au moins deux vannes (56), **caractérisé en ce qu**'un espace intérieur d'une pièces (5) creuse est traité et qu'au moins une station de plasma (3) est déplacée d'un positionnement d'introduction en un positionnement de sortie par une roue de traitement au plasma (2) en rotation, et en ce qu'une station de plasma (3) met à disposition plusieurs cavités (4) et qu'une vanne d'évacuation primaire (56) du bloc de vannes (54) produit une première dépression et qu'une vanne d'évacuation secondaire (57) du bloc de vannes (54) augmente cette dépression en en produisant une seconde de pression inférieure à celle de la première, le bloc de vannes (54) étant agencé de façon à former une partie du socle (30) de la chambre.

2. Procédé selon la revendication 1, **caractérisé en ce qu**'une dépression est commandée par au moins l'une des vannes (55).

3. Procédé selon la revendication 1 ou 2, **caractérisé en ce que** deux vannes (55) au moins sont utilisées pour l'application d'au moins deux degrés de dépression différents.

4. Procédé selon l'une des revendications 1 à 3, **caractérisé en ce qu**'une évacuation d'une cavité (4) de la station de plasma (3) a lieu à travers le fond (29) de la chambre.

5. Procédé selon l'une des revendications 1 à 4, **caractérisé en ce qu**'un gaz de procédé est introduit par le fond (29) de la chambre.

6. Procédé selon l'une des revendications 1 à 5, **caractérisé en ce que** le gaz de procédé est introduit par une lance (36) dans un espace intérieur de la pièce (5).

7. Procédé selon l'une des revendications 1 à 6, **caractérisé en ce qu**'un premier degré de dépression est appliqué par une vanne d'évacuation primaire (56).

8. Procédé selon l'une des revendications 1 à 7, **caractérisé en ce qu**'un espace intérieur de la pièces (5) et un autre espace intérieur de la station de traitement sont, temporairement au moins, branchés simultanément sur le dispositif d'application de la dépression.

9. Procédé selon l'une des revendications 1 à 8, **caractérisé en ce que** l'espace intérieur de la pièces (5) et l'autre espace intérieur de la chambre à plasma (17) sont, temporairement au moins, branchés simultanément sur un système de production d'une dépression de pression inférieure à celle de la première dépression.

10. Procédé selon l'une des revendications 1 à 9, **caractérisé en ce que** l'espace intérieur de la pièce (5) est, pendant une période prolongée, branché sur l'un au moins des systèmes de production d'une dépression.

11. Procédé selon l'une des revendications 1 à 10, **caractérisé en ce qu**'une partie au moins de la chambre à plasma (17) est temporairement, par l'intermédiaire du bloc de vannes (54), branchée sur une pression ambiante.

12. Procédé selon l'une des revendications 1 à 10, **caractérisé en ce qu**'une partie au moins de l'espace intérieur de la pièce (5) est temporairement, par l'intermédiaire du bloc de vannes (54), branchée sur une pression ambiante.

13. Procédé selon l'une des revendications 1 à 12, **caractérisé en ce que** des microondes produites par un générateur de microondes (19) sont introduites dans la cavité (4) au niveau du couvercle (31) de la chambre.

14. Procédé selon l'une des revendications 1 à 13, **caractérisé en ce que** la pièce (5) traitée est une pièce en matière plastique thermoplastique.

15. Procédé selon l'une des revendications 1 à 14, **caractérisé en ce que** la pièce (5) traitée est un récipient.

16. Procédé selon l'une des revendications 1 à 15, **caractérisé en ce que** la pièce (5) traitée est une bouteille pour boissons.

17. Procédé selon l'une des revendications 1 à 16, **caractérisé en ce qu'**un gaz plasmagène d'au moins une composition prédéfinissable est branché par l'intermédiaire d'au moins une vanne de gaz de processus (62, 63) sur une alimentation en moyens de production.

18. Procédé selon l'une des revendications 1 à 17, **caractérisé en ce que** le traitement au plasma est réalisé sous forme de revêtement par plasma.

19. Procédé selon l'une des revendications 1 à 18, **caractérisé en ce que** le traitement au plasma fait appel à un plasma basse pression.

20. Procédé selon l'une des revendications 1 à 19, **caractérisé en ce que** l'on effectue une polymérisation par plasma.

21. Procédé selon l'une des revendications 1 à 20, **caractérisé en ce que** le plasma dépose en partie au moins des substances organiques.

22. Procédé selon l'une des revendications 1 à 20, **caractérisé en ce que** le plasma dépose en partie au moins des substances anorganiques.

23. Procédé selon l'une des revendications 1 à 22, **caractérisé en ce que** le plasma dépose une substance améliorant les propriétés de barrière de la pièce (5).

24. Procédé selon la revendication 23, **caractérisé en ce qu**'est en outre déposé un agent de pontage pour améliorer l'adhésion de la substance à la surface de la pièce (5).

25. Procédé selon l'une des revendications 1 à 24, **caractérisé en ce que** deux pièces (5) au moins sont traitées simultanément dans une cavité commune.

26. Procédé selon l'une des revendications 1 à 17, **caractérisé en ce que** le traitement au plasma appliqué est une stérilisation par plasma.

27. Procédé selon l'une des revendications 1 à 17, **caractérisé en ce que** le traitement au plasma appliqué est une activation de surface de la pièce (5).

28. Dispositif de traitement au plasma de pièces (5) présentant, pour recevoir ces pièces (5), au moins une chambre à plasma (17) agencée dans la zone d'une station de traitement, cette chambre à plasma (17) étant délimitée par un fond de chambre (29), un couvercle de chambre (31) ainsi qu'une paroi latérale (18) et munie d'au moins un élément de maintien (46) assurant le positionnement de la pièce, et présentant dans une zone du fond (29) de la chambre à l'opposé à la chambre à plasma (17) un bloc de vannes (54) muni d'au moins deux vannes (56) commandant un branchement de la chambre à plasma (17) sur au moins une alimentation en moyens de production, **caractérisé en ce que** le bloc de vannes (54) présente une vanne d'évacuation primaire (56) appliquant une première dépression, et **en ce que** le bloc de vannes (54) présente une vanne d'évacuation secondaire (57) appliquant une seconde dépression de pression inférieure à celle de la première, et **en ce que** la station de plasma (3) est conçue pour appliquer un revêtement à l'intérieur d'une pièce (5) creuse, et **en ce qu'**au moins une station de plasma (3) est portée par une roue de traitement au plasma (2) en rotation, et **en ce que** plusieurs cavités (4) sont agencées dans la zone de la station de plasma (3), et que le bloc de vannes (54) forme une partie du socle (30) de la chambre.

29. Dispositif selon la revendication 28, **caractérisé en ce que** l'une au moins des vannes (55) est conçue pour appliquer une dépression.

30. Dispositif selon la revendication 28 ou 29, **caractérisé en ce que** le bloc de vannes (54) est conçu pour appliquer au moins deux différentes dépressions.

31. Dispositif selon l'une des revendications 28 à 30, **caractérisé en ce qu**'un canal à vide au moins est aménagé dans le fond (29) de la chambre pour l'évacuation d'une cavité (4) de la station de plasma (3).

32. Dispositif selon l'une des revendications 28 à 31, **caractérisé en ce qu'un** canal au moins est aménagé dans le fond (29) de la chambre pour l'adduction d'un gaz de procédé.

33. Dispositif selon l'une des revendications 28 à 32, **caractérisé en ce qu**'une lance (36) pour l'adduction d'un gaz de procédé dans un espace intérieur de la pièce (5) est agencée de façon à pouvoir être positionnée par rapport au fond (29) de la chambre.

34. Dispositif selon la revendication 28, **caractérisé en ce que** la vanne d'évacuation primaire (56) assure au moins temporairement le branchement aussi bien d'un espace intérieur de la pièce (5) qu'un autre espace intérieur de la chambre à plasma (17) à système commun de production d'une dépression.

35. Dispositif selon la revendication 28, **caractérisé en ce que** la vanne d'évacuation secondaire (57) raccorde au moins temporairement exclusivement un espace intérieur de la pièce (5) à la source de dépression.

36. Dispositif selon l'une des revendications 28 à 35, **caractérisé en ce que** le bloc de vannes (54) présente une vanne de purge (60) de la pièce assurant la communication entre un espace intérieur de la pièce (5) avec une pression ambiante.

37. Dispositif selon l'une des revendications 28 à 36, **caractérisé en ce que** le bloc de vannes (54) présente une vanne de purge (61) de la chambre assurant la communication entre un espace intérieur de la chambre à plasma (17) avec une pression ambiante.

38. Dispositif selon l'une des revendications 28 à 37, **caractérisé en ce qu**'un générateur de microondes (19) est placé au niveau du couvercle (31) de la chambre.

39. Dispositif selon l'une des revendications 28 à 38, **caractérisé en ce que** la station de plasma (3) est conçue pour appliquer un revêtement d'une matière plastique thermoplastique à l'intérieur d'une pièce (5).

40. Dispositif selon l'une des revendications 28 à 39, **caractérisé en ce que** la station de plasma (3) est conçue pour appliquer un revêtement à l'intérieur d'une pièce (5) en forme de récipient.

41. Dispositif selon l'une des revendications 28 à 40, **caractérisé en ce que** la station de plasma (3) est conçue pour appliquer un revêtement à l'intérieur d'une pièce (5) en forme de bouteille pour boissons.

42. Dispositif selon l'une des revendications 28 à 41, **caractérisé en ce qu**'une paroi (18) prévue pour mettre à disposition au moins deux cavités (4) est placée de façon à pouvoir être positionnée.

43. Dispositif selon l'une des revendications 28 à 42, **caractérisé en ce que** le bloc de vannes (54) présente au moins une vanne pour gaz de procédé (62, 63).

44. Dispositif selon l'une des revendications 28 à 43, **caractérisé en ce que** le bloc de vannes (54) est placé perpendiculairement sous le fond (29) de la chambre.

45. Dispositif selon l'une des revendications 28 à 43, **caractérisé en ce que** le bloc de vannes (54) est essentiellement agencé à côté du socle (30) de la chambre.

46. Dispositif selon l'une des revendications 28 à 45, **caractérisé en ce que** l'une au moins des vannes pour gaz de procédé (62, 63) est branchée sur un élément de raccord orienté perpendiculairement vers le bas.

47. Dispositif selon la revendication 46, **caractérisé en ce que** l'élément de raccord est réalisé sous forme d'un raccord vers un chariot porteur (37) portant la lance (36).

48. Dispositif selon la revendication 46 ou 47, **caractérisé en ce que** un canal de déviation du gaz plasmagène est aménagé au niveau du chariot (37) portant la lance pour dévier le gaz plasmagène de l'élément de raccord en direction de la lance (36).

49. Dispositif selon l'une des revendications 28 à 48, **caractérisé en ce que** l'une au moins des vannes (55) est réalisée sous forme de vanne à commande électromagnétique.
